# FASCICULE DE BREVET EUROPEEN

(11) **EP 3 054 755 B1**
(45) Date de publication et mention de la délivrance du brevet: **24.06.2020**
(21) Numéro de dépôt: 16153278.3
(22) Date de dépôt: 29.01.2016
(51) Int. Cl.: H05K 7/20, H01L 23/473

(54) **SYSTÈMES ÉLECTRIQUES AVEC DES MODULES DE PUISSANCE ET DES RACCORDS DE CONNEXION DE BOITIERS DE REFROIDISSEMENT DES MODULES DE PUISSANCE**
ELEKTRISCHE SYSTEME MIT LEISTUNGSMODULEN UND VERBINDUNGSANSCHLÜSSEN FÜR DIE KÜHLGEHÄUSE DER LEISTUNGSMODULE
ELECTRICAL SYSTEMS WITH POWER MODULES AND COUPLINGS FOR CONNECTING BOXES FOR COOLING THE POWER MODULES

(30) Priorité: 03.02.2015 FR 1550810
(43) Date de publication de la demande: 10.08.2016
(73) Titulaire: Valeo Systèmes de Contrôle Moteur, 95800 Cergy St Christophe (FR)
(72) Inventeur: DENIOT, Roger, 78300 POISSY (FR)
(74) Mandataire: Argyma

(56) Documents cités:
- DE-A1-102011 121 064
- DE-A1-102012 222 011
- US-A1- 2010 071 396
- US-A1- 2012 211 213
- US-A1- 2014 185 243

## Description

### DOMAINE TECHNIQUE

La présente invention concerne le refroidissement des modules de puissance.

Un module de puissance est un élément électrique destiné à travailler par exemple avec des courants d'intensité supérieure à 1 A.

### ARRIÈRE-PLAN TECHNOLOGIQUE

La publication US 2013/0020694 A1 de la demande de brevet américaine US 13/547,937 décrit un module de puissance comportant :
- un étage de puissance,
- au moins un dispositif de refroidissement de l'étage de puissance par circulation de fluide caloporteur, le dispositif de refroidissement comportant un premier passage de fluide caloporteur et un deuxième passage de fluide caloporteur.

Cette publication prévoit de connecter entre eux les modules de puissance pour former des systèmes électriques complexes.

Les documents US2014/185243 A1 et DE 10 2011 121064 décrivent également des modules de puissance connectables entre eux pour former des systèmes électrique complexes.

L'invention a pour but de proposer une manière efficace de connecter des boîtiers de refroidissement pour permettre la circulation de fluide caloporteur.

### RÉSUMÉ DE L'INVENTION

À cet effet, il est proposé des dispositifs de refroidissement modulaires, c'est-à-dire aptes à se connecter les uns aux autres, par exemple en utilisant en utilisant des raccords. Grâce au concept de modularité, peu de pièces différentes sont nécessaires.

En particulier, il est proposé un système électrique comportant :
- un module de puissance comportant :
   - un étage de puissance,
   - au moins un boîtier de refroidissement de l'étage de puissance par circulation de fluide caloporteur, le boîtier de refroidissement comportant un premier passage de fluide caloporteur et un deuxième passage de fluide caloporteur,
le boîtier de refroidissement comporte, du côté du premier passage, un premier système d'attache et, du côté du deuxième passage, un deuxième système d'attache,
le système électrique comporte en outre un raccord comportant :
- un premier passage de fluide caloporteur,
- un premier système d'attache complémentaire du premier système d'attache du boîtier de refroidissement de manière à pouvoir maintenir le premier passage du raccord connecté au premier passage du boîtier de refroidissement,
- un deuxième système d'attache complémentaire du deuxième système d'attache du boîtier de refroidissement de manière à pouvoir maintenir le premier passage du raccord connecté au deuxième passage du boîtier de refroidissement,
caractérisé en ce que ledit raccord comporte en outre :
- un deuxième passage de fluide caloporteur,
- un troisième passage de fluide caloporteur,
le deuxième passage et le troisième passage du raccord étant complémentaires l'un de l'autre de manière à ce que le deuxième passage du raccord et le troisième passage d'un autre raccord identique au raccord puisse s'emmancher l'un dans l'autre, et le troisième passage du raccord et le deuxième passage d'un autre raccord identique au raccord puisse s'emmancher l'un dans l'autre.

Ainsi, plusieurs boîtiers de refroidissement de modules de puissance différents peuvent facilement être connectés en parallèle, au moyen de raccords.

Notamment, le boîtier de refroidissement s'étend essentiellement suivant un plan. En particulier, le premier et le deuxième passages du boîtier de refroidissement sont situés à des côtés opposés du boîtier de refroidissement. Notamment, le premier et le deuxième passage du boîtier de refroidissement définissent respectivement un orifice qui s'étend dans une direction transverse au plan du boîtier de refroidissement, notamment perpendiculaire.

De façon optionnelle, l'un parmi le premier système d'attache du boîtier de refroidissement et le premier système d'attache du raccord comporte au moins une butée et l'autre comporte, pour chaque butée, une languette destinée à engager la butée, et/ou dans lequel l'un parmi le deuxième système d'attache du boîtier de refroidissement et le deuxième système d'attache du raccord comporte au moins une butée et l'autre comporte, pour chaque butée, une languette destinée à engager la butée.

De façon optionnelle également, le premier passage du boîtier de refroidissement est destiné à s'emmancher dans le premier passage du raccord et le deuxième passage du boîtier de refroidissement est destiné à s'emmancher dans le premier passage du raccord.

De façon optionnelle également, l'étage de puissance s'étend essentiellement dans un plan horizontal et dans lequel le deuxième passage et le troisième passage du raccord sont destinés à être orientés respectivement vers le haut et le bas d'une direction bas/haut perpendiculaire au plan horizontal lorsque le premier passage du raccord connecté au premier passage ou au deuxième passage du boîtier de refroidissement.

### DESCRIPTION DES FIGURES

Un mode de réalisation de l'invention va à présent être décrit à titre d'exemple uniquement, en référence aux figures suivantes.
La figure 1 est une vue en trois dimensions d'un module de puissance comportant deux boîtiers de refroidissement.
La figure 2 est une vue en trois dimensions d'un raccord double comportant deux raccords d'un premier type destinés à connecter entre eux des boîtiers de refroidissement de modules de puissance .
La figure 3 est une vue en trois dimensions d'un raccord double monté sur les deux boîtiers de refroidissement du module de puissance de la figure 1.
La figure 4 est une vue en trois dimensions de deux modules de puissance dont les boîtiers sont connectés par le raccord double de la figure 2.
La figure 5 est une vue en trois dimensions des deux modules de puissance de la figure 4, avec un des boîtiers de refroidissement en outre connecté à un raccord d'un deuxième type.

### DESCRIPTION DÉTAILLÉE

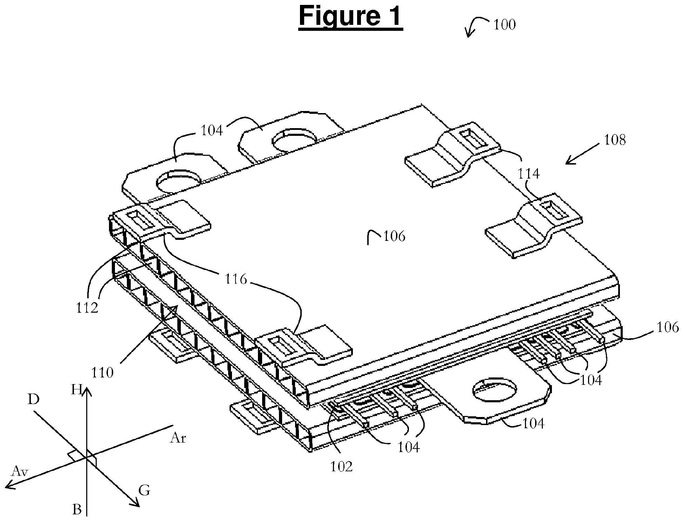

En référence aux figures 1 à 5, les différents éléments d'un système électrique modulaire vont à présent être décrits par rapport à un repère arbitraire orthogonal formé des directions arrière-avant Ar-Av, bas-haut B-H et droite-gauche D-G.

En référence à la figure 1, un module de puissance 100 va à présent être décrit.

Le module de puissance 100 comporte tout d'abord un étage de puissance 102 de forme générale plane et s'étendant essentiellement dans le plan horizontal. L'étage de puissance 102 présente une face supérieure orientée vers le haut et une face inférieure orientée vers le bas. Par exemple, l'étage de puissance 102 comporte deux plaques de substrat isolant s'étendant essentiellement horizontalement, l'une en face de l'autre. Des composants électroniques sont fixés sur l'une ou l'autre des faces en vis-à-vis des plaques de substrat isolant, de manière à s'étendre entre les deux plaques de substrat isolant. Les faces supérieure et inférieure de l'étage de puissance 102 sont alors formées des faces des deux plaques de substrat isolant opposées aux faces en vis-à-vis.

L'étage de puissance 102 comporte en outre des connexions électriques 104 connectées aux composants électroniques et se projetant sur le côté droit et sur le côté gauche.

Le module de puissance 100 comporte en outre deux boîtiers de refroidissement 106 de l'étage de puissance 102 par circulation de fluide caloporteur. Dans l'exemple décrit, les deux boîtiers de refroidissement 106 sont similaires et plaqués respectivement contre les faces supérieure et inférieure de l'étage de puissance 102.

Par la suite, un seul boîtier de refroidissement 106 sera décrit, l'autre étant similaire.

Le boîtier de refroidissement 106 est de forme générale parallélépipédique et s'étend essentiellement horizontalement. Le boîtier de refroidissement 106 comporte un passage arrière 108 et un passage avant 110 de fluide caloporteur, reliés l'un à l'autre par au moins un conduit 112 d'écoulement du fluide caloporteur. Le passage arrière 108 et le passage avant 110 sont de forme générale rectangulaire avec les coins arrondis. Un des passages 108, 110 est destiné à l'entrée de fluide caloporteur et l'autre à la sortie de fluide caloporteur. Les passages arrière 108 et avant 110 définissent chacun un orifice qui s'étend perpendiculairement au plan horizontal du boîtier de refroidissement 106.

Le boîtier de refroidissement 106 comporte en outre, du côté du passage arrière 108, un système d'attache arrière 114 comportant dans l'exemple décrit des languettes flexibles se projetant vers l'arrière et présentant chacune une ouverture de réception d'ergot.

Le boîtier de refroidissement 106 comporte en outre, du côté du passage avant 110, un système d'attache avant 116 comportant dans l'exemple décrit des languettes flexibles se projetant vers l'avant et présentant chacune une ouverture de réception d'ergot.

Un système électrique peut comporter plusieurs modules de puissance 100 présentant chacun au moins un boîtier de refroidissement. Les boîtiers de refroidissement de ces modules de puissances sont similaires au boîtier de refroidissement 106 décrit précédemment. Pour connecter entre eux les boîtiers de refroidissement 106, une panoplie de raccords est prévue.

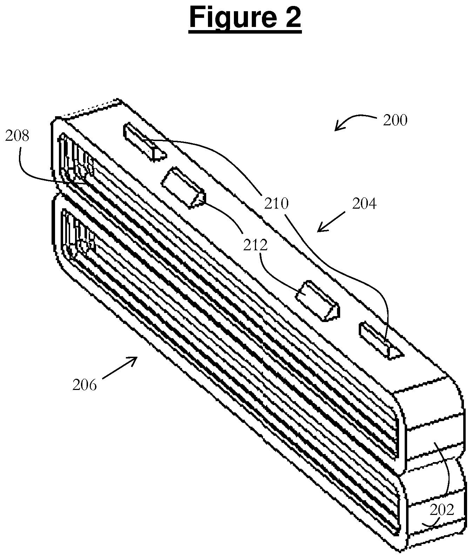

En référence à la figure 2, la panoplie de raccords comporte au moins un raccord double 200 qui va à présent être décrit.

Le raccord double 200 comporte deux raccords 202 d'un premier type, s'étendant l'un au-dessus de l'autre. Dans l'exemple décrit, les deux raccords 202 sont similaires et solidaires l'un de l'autre. Le raccord 202 du dessus est destiné à connecter ensemble les deux boîtiers de refroidissement 106 du dessus de deux modules de puissance 100 s'étendant l'un à côté de l'autre. Le raccord 202 du dessous est destiné à connecter ensemble les deux boîtiers de refroidissement 106 du dessous des deux modules de puissance 100 s'étendant l'un à côté de l'autre.

Par la suite, un seul raccord 202 sera décrit, l'autre étant similaire.

Le raccord 202 est de forme générale tubulaire de section rectangulaire avec les coins arrondis. Le raccord 202 présente un passage arrière 204 de fluide caloporteur et un passage avant 206 de fluide caloporteur. Les deux passages 204, 206 sont de forme générale rectangulaire avec les coins arrondis. Les passages arrière 204 et avant 206 définissent chacun un orifice qui s'étend perpendiculairement à un axe général avant-arrière du raccord 202.

Le passage avant 110, respectivement arrière 108, du boîtier de refroidissement 106 est destiné à s'emmancher dans le passage arrière 204, respectivement avant 206, du raccord 202 pour connecter les passages 110, 204, respectivement 108, 206.

Le raccord 202 comporte en outre, sur une face interne, un joint d'étanchéité 208 destiné à assurer l'étanchéité avec le passage 106, 108 emmanché dans le raccord 202. Par exemple, le joint d'étanchéité est un joint d'étanchéité à lèvre 208, un joint torique ou tout autre joint permettant d'obtenir une étanchéité.

Le raccord 202 comporte en outre, du côté du passage arrière 204, un système d'attache arrière 210 et, du côté du passage avant 206, un système d'attache avant 212. Le système d'attache arrière 210 du raccord 202 et le système d'attache avant 116 de la boîte de refroidissement 106 sont complémentaires l'un de l'autre de manière à pouvoir maintenir le passage arrière 204 du raccord 202 connecté au passage avant 110 du boîtier de refroidissement 106. En outre, le système d'attache avant 212 du raccord 202 et le système d'attache arrière 114 du boîtier de refroidissement 106 sont complémentaires l'un de l'autre de manière à pouvoir maintenir le passage avant 206 du raccord 202 connecté au passage arrière 108 du boîtier de refroidissement 106.

Dans l'exemple décrit, les systèmes d'attache arrière 210 et avant 212 du raccord 202 comportent des ergots destinés à engager les ouvertures des languettes flexibles de respectivement les systèmes d'attache avant 116 et arrière 114 du boîtier de refroidissement 106. Dans l'exemple décrit les ergots du système d'attache arrière 210 se trouvent respectivement à droite et à gauche des ergots du système d'attache avant 212. En outre, pour faciliter l'engagement avec les languettes, les ergots du système d'attache arrière 210 présentent un côté arrière biseauté, tandis que les ergots du systèmes d'attache avant 212 présentent un côté avant biseauté.

Alternativement, au lieu d'être solidaires l'un de l'autre, les deux raccords 202 du raccord double 200 pourraient être des pièces indépendantes l'une de l'autre.

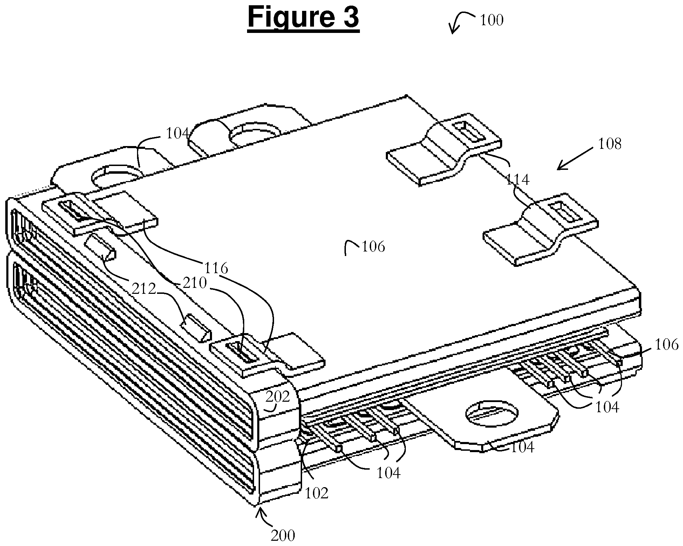

En référence à la figure 3, le boîtier de refroidissement 106 et le raccord 202 dans lequel le passage avant 110 du boîtier de refroidissement 106 est emmanché forment ensemble un dispositif de refroidissement 106, 202 de l'étage de puissance 102 par circulation de fluide caloporteur. Ce dispositif de refroidissement 106, 202 comporte le système d'attache 114 et le système d'attache 212.

Le raccord 202 prolonge le boîtier de refroidissement 106 vers l'avant pour former un manchon entourant le passage avant 110 emmanché dans le passage arrière 204 du raccord 202. Le passage arrière 108 d'un autre boîtier de refroidissement 106 est alors destiné à s'emmancher dans le passage avant 206 du raccord 202.

Le système d'attache avant 212 du raccord 202 peut s'engager avec le système d'attache arrière 114 de l'autre boîtier de refroidissement 106 pour maintenir les passages avant 110 et arrière 108 des deux boîtiers de refroidissement 106 connectés, en évitant leur séparation dans la direction arrière-avant.

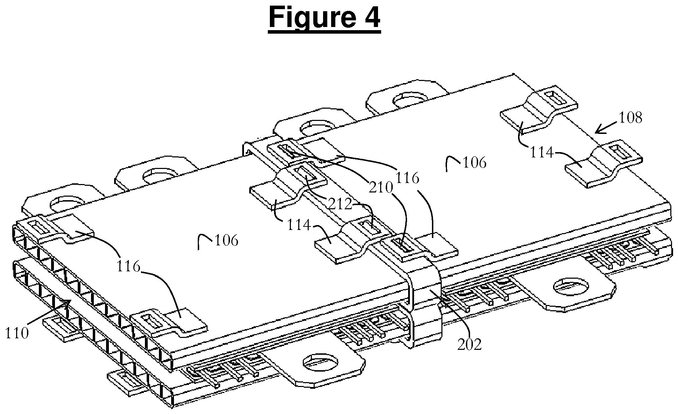

En référence à la figure 4, le passage arrière 108 d'un premier boîtier de refroidissement 106 d'un premier module de puissance 100 est emmanché dans le passage avant 206 d'un raccord 202. En outre, le passage avant 110 d'un deuxième boîtier de refroidissement 106 d'un deuxième module de puissance 100 est emmanché dans le passage arrière 204 du raccord 202. Ainsi, grâce au raccord 202, le passage arrière 108 du premier boîtier de refroidissement 106 et le passage avant 110 du deuxième boîtier de refroidissement 106 sont maintenus connectés.

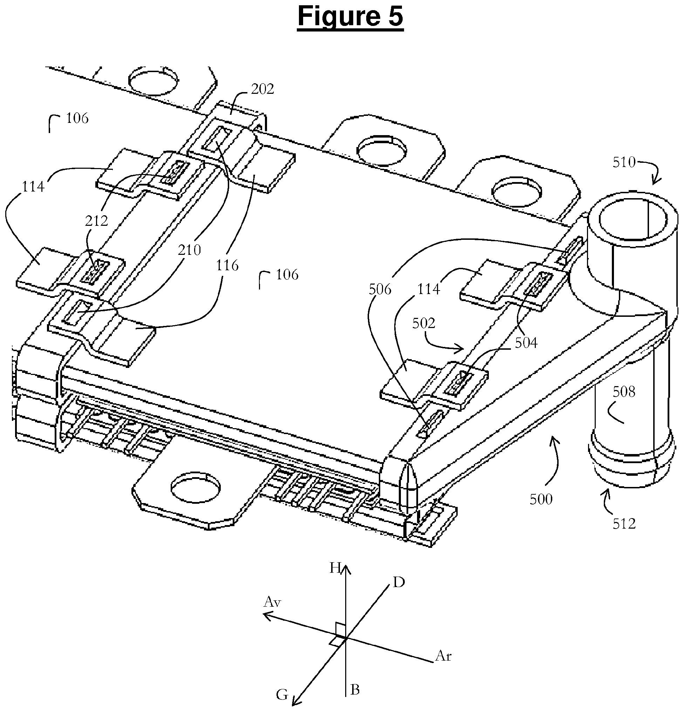

En référence à la figure 5, la panoplie de raccords comporte en outre au moins un raccord 500 d'un deuxième type.

Le raccord 500 comporte un passage avant 502 dans lequel le passage avant 110 et le passage arrière 112 d'un boîtier de refroidissement 106 est destiné à s'emmancher.

Le raccord 500 comporte en outre, du côté du passage avant 502, des premier et deuxième systèmes d'attache 504, 506 complémentaires respectivement du système d'attache arrière 114 et du système d'attache avant 116 du boîtier de refroidissement 106. Dans l'exemple décrit, le premier système d'attache 504 comporte des ergots 504 destinés à engager les ouvertures des languettes flexibles du système d'attache arrière 114 du boîtier de refroidissement 106, tandis que le deuxième système d'attache 506 comporte des ergots 506 destinés à engager les ouvertures des languettes flexibles du système d'attache avant 116 du boîtier de refroidissement 106.

Le raccord 500 comporte en outre un conduit vertical 508 présentant, à une extrémité supérieure du conduit 508, un passage supérieur 510 orienté vers le haut et, à une extrémité inférieure du conduit 508, un passage inférieur 512 orienté vers le bas. Les passages 510, 512 sont complémentaires l'une de l'autre de manière à ce que le passage supérieur 510 et le passage inférieur 512 de deux raccords 500 disposés l'un au-dessus de l'autre puissent s'emmancher l'un dans l'autre. Dans l'exemple décrit, le passage inférieur 512 est destiné à s'emmancher dans le passage supérieur 510.

Ainsi, les modules de puissance 100 peuvent être assemblés verticalement, les uns au-dessus des autres, avec leurs boîtiers de refroidissement 106 connectés les uns à la suite des autres.

La présente invention n'est pas limitée au mode de réalisation décrit précédemment. Il sera en effet apparent à l'homme du métier que des modifications peuvent y être apportées.

Ainsi, les formes des raccords peuvent changer pour s'adapter à l'application. Par exemple, le conduit 508 du raccord du deuxième type 500 peut comporter un coude pour s'adapter à des contraintes de place liées à l'environnement.

Par exemple, un module de puissance peut ne comporter qu'un seul boîtier de refroidissement de l'étage de puissance. Dans ce cas, l'autre face de l'étage de puissance peut être refroidi par une boîte à eau, c'est-à-dire par une circulation de fluide caloporteur dans une paroi d'un boîtier dans lequel le module de puissance se trouve, la face à refroidir étant plaquée contre cette paroi.

**LISTE DES RÉFÉRENCES**

| | |
|---|---|
| Module de puissance | 100 |
| Étage de puissance | 102 |
| Connexions électriques | 104 |
| Boîtier de refroidissement | 106 |
| Passage arrière du boîtier de refroidissement | 108 |
| Passage avant du boîtier de refroidissement | 110 |
| Conduits | 112 |
| Système d'attache arrière du boîtier de refroidissement | 114 |
| Système d'attache avant du boîtier de refroidissement | 116 |
| Raccord double | 200 |
| Raccord du premier type | 202 |
| Passage arrière du raccord du premier type | 204 |
| Passage avant du raccord du premier type | 206 |
| Joint | 208 |
| Système d'attache arrière du raccord du premier type | 210 |
| Système d'attache avant du raccord du premier type | 212 |
| Raccord du deuxième type | 500 |
| Passage avant du raccord du deuxième type | 502 |
| Premier système d'attache avant du raccord du deuxième type | 504 |
| Deuxième système d'attache avant du raccord du deuxième type | 506 |
| Conduit vertical | 508 |
| Passage supérieur du conduit vertical | 510 |
| Passage inférieur du conduit vertical | 512 |

## Revendications

1. Système électrique comportant:
- un module de puissance (100) comportant :
- un étage de puissance (102),
- au moins un boîtier de refroidissement (106) de l'étage de puissance (102) par circulation de fluide caloporteur, le boîtier de refroidissement (106) comportant un premier passage (108) de fluide caloporteur et un deuxième passage (110) de fluide caloporteur,
le boîtier de refroidissement (106) comporte, du côté du premier passage (108), un premier système d'attache (114) et, du côté du deuxième passage (110), un deuxième système d'attache (116),
le système électrique comporte en outre un raccord (500) comportant :
- un premier passage (502) de fluide caloporteur,
- un premier système d'attache (504) complémentaire du premier système d'attache (114) du boîtier de refroidissement (106) de manière à pouvoir maintenir le premier passage (502) du raccord (500) connecté au premier passage (108) du boîtier de refroidissement (106),
- un deuxième système d'attache (506) complémentaire du deuxième système d'attache (116) du boîtier de refroidissement (106) de manière à pouvoir maintenir le premier passage (502) du raccord (500) connecté au deuxième passage (110) du boîtier de refroidissement (106),
**caractérisé en ce que** ledit raccord (500) comporte en outre :
- un deuxième passage (510) de fluide caloporteur,
- un troisième passage (512) de fluide caloporteur,
le deuxième passage (510) et le troisième passage (512) du raccord (500) étant complémentaires l'un de l'autre de manière à ce que le deuxième passage (510) du raccord (500) et le troisième passage d'un autre raccord identique au raccord (500) puisse s'emmancher l'un dans l'autre, et le troisième passage (512) du raccord (500) et le deuxième passage d'un autre raccord identique au raccord (500) puisse s'emmancher l'un dans l'autre.

2. Système électrique selon la revendication 1, dans lequel l'un parmi le premier système d'attache (114) du boîtier de refroidissement (106) et le premier système d'attache (504) du raccord (500) comporte au moins une butée et l'autre comporte, pour chaque butée, une languette destinée à engager la butée, et/ou dans lequel l'un parmi le deuxième système d'attache (116) du boîtier de refroidissement (106) et le deuxième système d'attache (506) du raccord (500) comporte au moins une butée et l'autre comporte, pour chaque butée, une languette destinée à engager la butée.

3. Système électrique selon la revendication 1 ou 2, dans lequel le premier passage (108) du boîtier de refroidissement (106) est destiné à s'emmancher dans le premier passage (502) du raccord (500) et le deuxième passage (110) du boîtier de refroidissement (106) est destiné à s'emmancher dans le premier passage (502) du raccord (500).

4. Système électrique selon l'une quelconque des revendications 1 à 3, dans lequel l'étage de puissance s'étend essentiellement dans un plan horizontal et dans lequel le deuxième passage (510) et le troisième passage (512) du raccord (500) sont destinés à être orientés respectivement vers le haut et le bas d'une direction bas/haut perpendiculaire au plan horizontal lorsque le premier passage (502) du raccord (500) connecté au premier passage (108) ou au deuxième passage (110) du boîtier de refroidissement (106).

## Patentansprüche

1. Elektrisches System, das Folgendes umfasst:
- ein Leistungsmodul (100), das Folgendes umfasst:
- eine Leistungsstufe (102),
- mindestens ein Kühlgehäuse (106) der Leistungsstufe (102) durch Zirkulation von Wärmeflüssigkeit, wobei das Kühlgehäuse (106) eine erste Wärmeflüssigkeitspassage (108) und eine zweite Wärmeflüssigkeitspassage (110) umfasst,
wobei das Kühlgehäuse (106) auf der Seite der ersten Passage (108) ein erstes Anbringungssystem (114) und auf der Seite der zweiten Passage (110) ein zweites Anbringungssystem (116) umfasst,
wobei das elektrische System außerdem einen Anschluss (500) umfasst, der Folgendes umfasst:
- eine erste Wärmeflüssigkeitspassage (502),
- ein erstes Anbringungssystem (504), das zu dem ersten Anbringungssystem (114) des Kühlgehäuses (106) derart komplementär ist, dass es die erste Passage (502) des Anschlusses (500) mit der ersten Passage (108) des Kühlgehäuses (106) verbunden halten kann,
- ein zweites Anbringungssystem (506), das zu dem zweiten Anbringungssystem (116) des Kühlgehäuses (106) derart komplementär ist, dass es die erste Passage (502) des Anschlusses (500) mit der zweiten Passage (110) des Kühlgehäuses (106) verbunden halten kann,
**dadurch gekennzeichnet, dass** der Anschluss (500) außerdem Folgendes umfasst:
- eine zweite Wärmeflüssigkeitspassage (510),
- eine dritte Wärmeflüssigkeitspassage (512),
wobei die zweite Passage (510) und die dritte Passage (512) des Anschlusses (500) zueinander derart komplementär sind, dass die zweite Passage (510) des Anschlusses (500) und die dritte Passage eines anderen Anschlusses, der mit dem Anschluss (500) identisch ist, ineinander greifen können, und wobei die dritte Passage (512) des Anschlusses (500) und die zweite Passage eines anderen Anschlusses, der mit dem Anschluss (500) identisch ist, ineinander greifen können.

2. Elektrisches System nach Anspruch 1, wobei eines des ersten Anbringungssystems (114) des Kühlgehäuses (106) und des ersten Anbringungssystems (504) des Anschlusses (500) mindestens einen Anschlag trägt, und das andere für jeden Anschlag eine Lasche umfasst, die dazu bestimmt ist, in den Anschlag einzugreifen, und/oder wobei eines des zweiten Anbringungssystems (116) des Kühlgehäuses (106) und des zweiten Anbringungssystems (506) des Anschlusses (500) mindestens einen Anschlag umfasst, und das andere für jeden Anschlag eine Lasche umfasst, die dazu bestimmt ist, in den Anschlag einzugreifen.

3. Elektrisches System nach Anspruch 1 oder 2, wobei die erste Passage (108) des Kühlgehäuses (106) dazu bestimmt ist, in die erste Passage (502) des Anschlusses (500) einzugreifen, und die zweite Passage (110) des Kühlgehäuses (106) dazu bestimmt ist, in die ersten Passage (502) des Anschlusses (500) einzugreifen.

4. Elektrisches System nach einem der Ansprüche 1 bis 3, wobei sich die Leistungsstufe im Wesentlichen in einer horizontalen Ebene erstreckt, und wobei die zweite Passage (510) und die dritte Passage (512) des Anschlusses (500) dazu bestimmt sind, jeweils nach oben und nach unten einer Abwärts-/Aufwärtsrichtung senkrecht zu der horizontalen Ebene ausgerichtet zu sein, wenn die erste Passage (502) des Anschlusses (500) mit der ersten Passage (108) oder der zweiten Passage (110) des Kühlgehäuses (106) verbunden ist.

## Claims

1. Electrical system including:
- a power module (100) including:
- a power stage (102);
- at least one cooling package (106) for cooling the power stage (102) by circulating heat transfer fluid, the cooling package (106) including a first passage (108) for heat transfer fluid and a second passage (110) for heat transfer fluid,
the cooling package (106) includes, on the first-passage (108) side, a first attachment system (114) and, on the second-passage (110) side, a second attachment system (116),
the electrical system further includes a connector (500) including:
- a first passage (502) for heat transfer fluid;
- a first attachment system (504) that is complementary to the first attachment system (114) of the cooling package (106) so as to be able to keep the first passage (502) of the connector (500) connected to the first passage (108) of the cooling package (106);
- a second attachment system (506) that is complementary to the second attachment system (116) of the cooling package (106) so as to be able to keep the first passage (502) of the connector (500) connected to the second passage (110) of the cooling package (106),
**characterized in that** said connector (500) further includes:
- a second passage (510) for heat transfer fluid;
- a third passage (512) for heat transfer fluid, the second passage (510) and the third passage (512) of the connector (500) being complementary to one another in such a way that the second passage (510) of the connector (500) and the third passage of another connector, identical to the connector (500), are able to be fitted one into the other, and the third passage (512) of the connector (500) and the second passage of another connector, identical to the connector (500), are able to be fitted one into the other.

2. Electrical system according to Claim 1, wherein one from the first attachment system (114) of the cooling package (106) and the first attachment system (504) of the connector (500) includes at least one stop, and the other includes, for each stop, a tab that is intended to engage the stop, and/or wherein one from the second attachment system (116) of the cooling package (106) and the second attachment system (506) of the connector (500) includes at least one stop, and the other includes, for each stop, a tab that is intended to engage the stop.

3. Electrical system according to Claim 1 or 2, wherein the first passage (108) of the cooling package (106) is intended to be fitted into the first passage (502) of the connector (500), and the second passage (110) of the cooling package (106) is intended to be fitted into the first passage (502) of the connector (500).

4. Electrical system according to any one of Claims 1 to 3, wherein the power stage lies substantially in a horizontal plane and wherein the second passage (510) and the third passage (512) of the connector (500) are intended to be oriented upwards and downwards, respectively, in an upwards/downwards direction perpendicular to the horizontal plane when the first passage (502) of the connector (500) is connected to the first passage (108) or to the second passage (110) of the cooling package (106).
